Europäisches Patentamt

European Patent Office

Office européen des brevets

(19)

(11) Veröffentlichungsnummer : **0 110 114**
**B1**

## (12) EUROPÄISCHE PATENTSCHRIFT

(45) Veröffentlichungstag der Patentschrift :
15.04.87

(21) Anmeldenummer : 83110566.3

(22) Anmeldetag : 22.10.83

(51) Int. Cl.⁴ : **C 25 D 5/02,** H 05 K 3/10

(54) **Abdeckband für galvanische Prozesse.**

(30) Priorität : 02.11.82 DE 3240387

(43) Veröffentlichungstag der Anmeldung :
13.06.84 Patentblatt 84/24

(45) Bekanntmachung des Hinweises auf die Patenterteilung : 15.04.87 Patentblatt 87/16

(84) Benannte Vertragsstaaten :
BE FR GB IT NL SE

(56) Entgegenhaltungen :
US-A- 3 818 279
US-A- 3 928 692
US-A- 4 000 045

(73) Patentinhaber : **Beiersdorf Aktiengesellschaft**
**Unnastrasse 48**
**D-2000 Hamburg 20 (DE)**

(72) Erfinder : **Grah, Klaus**
**Klingenstrasse 70a**
**D-5650 Solingen 1 (DE)**

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

EP 0 110 114 B1

## Beschreibung

Die Erfindung bezieht sich auf ein für galvanische Prozesse bestimmtes Abdeckband.

Abdeckbänder für galvanische Prozesse sind bekannt und dienen dazu, insbesondere bei zu galvanisierenden Leiterplatten vorbestimmte Oberflächen von Niederschlägen freizuhalten, zu welchem Zweck die Oberflächen durch das Abdeckband abgedeckt werden. Den bekannten Abdeckbändern haften jedoch wesentliche Nachteile an, die in folgendem zu erblicken sind. Falls die zu galvanisierenden Oberflächen der Leiterplatte keine elektrische Verbindung zur Galvanokathode haben, muß bisher die Verbindung der zu galvanisierenden Oberflächen untereinander und mit der Galvanokathode durch zusätzliche Leiterbahnen hergestellt werden, indem bei Leiterplatten mit beispielsweise zu vergoldenden Steckerzungen eine jede Steckerzunge mit Hilfe einer zusätzlich auf der Leiterplatte erzeugten Leiterbahn an eine sich entlang der Steckerzungen erstreckende, ebenfalls auf der Leiterplatte erzeugte Leiterbahn angeschlossen wird, die ihrerseits an den mit der Galvanokathode verbundenen Blendrahmen der Leiterplatte gelegt ist. Das Erzeugen der zusätzlichen Leiterbahnen ist jedoch zeit- und arbeitsaufwendig. Es erfolgt ferner im Galvanisierungsprozeß eine nutzlose Vergoldung der zusätzlichen Leiterbahnen. Schließlich läßt sich auch nicht vermeiden, daß die auf der Leiterplatte befindliche Kupferschicht an den Stellen freiliegt, an denen beim Abtrennen des Blendrahmens von der Leiterplatte die einzelnen zusätzlichen Leiterbahnen von den Steckerzungen gelöst werden. Die Kupferschicht ist aber an diesen Stellen durch Umwelteinflüsse beeinträchtigt.

Es sind jedoch auch bereits Abdeckbänder für galvanische Prozesse bekannt, die mit einem elektrischen Leiter ausgerüstet sind. So beschreiben die US-Patentschriften 3 928 692 und 4 000 045 derartige Abdeckbänder, wobei der vorgesehene elektrische Leiter aus einer Kupferfolie besteht, die in das Abdeckband integriert ist. Bei der praktischen Anwendung derartiger Abdeckbänder zeigen sich jedoch erhebliche Mängel, etwa durch Unterwandern der galvanischen Flüssigkeiten, was zu einer Beschädigung der behandelten Leiterplatten und damit zum Ausschuß führt.

Aufgabe der Erfindung war es, hier Abhilfe zu schaffen, insbesondere ein Abdeckband für galvanische Prozesse zu schaffen, das die Nachteile des Standes der Technik nicht oder in wesentlich geringerem Ausmaß aufweist.

Gelöst wird diese Aufgabe durch ein Abdeckband, wie es im Patentanspruch näher gekennzeichnet ist.

Es zeigt sich bei der praktischen Anwendung eines solchen erfindungsgemäßen Abdeckbandes, daß eine Unterwanderung durch galvanische Flüssigkeiten in wesentlich geringerem Ausmaß auftritt als dies bei bisher bekannten derartigen Abdeckbändern der Fall war. Bei Vermeiden von Ausschuß ist damit das erfindungsgemäße Abdeckband für die Praxis in nicht vorhersehbarer Weise überaus geeignet.

Die Erfindung ist nachstehend in einem Ausführungsbeispiel anhand der Zeichnung näher erläutert. Es zeigt:

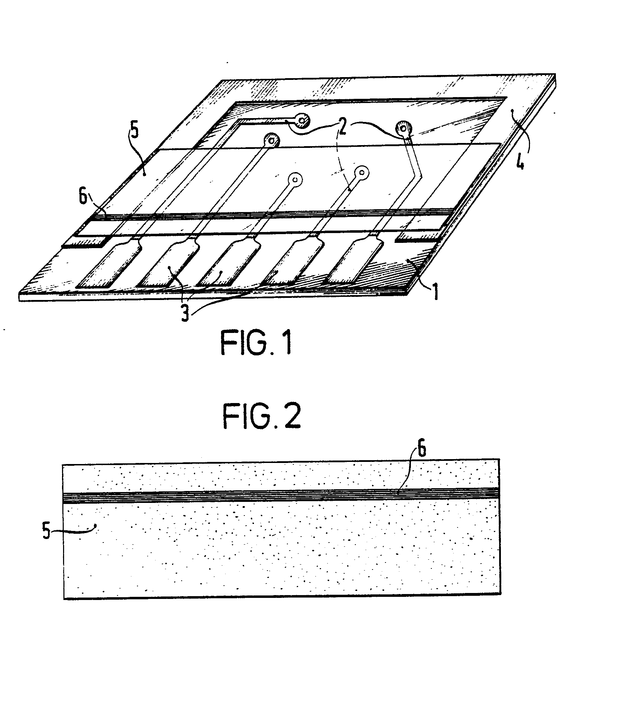

Figur 1 eine Leiterplatte mit Abdeckband in Draufsicht und

Figur 2 das Abdeckband in Draufsicht auf die mit der Beschichtung versehene Seite.

Mit 1 ist die Leiterplatte, mit 2 sind die Leiterbahnen, mit 3 die Steckerzungen und mit 4 ist der Blendrahmen der Leiterplatte 1 bezeichnet. Die Leiterplatte 1 und deren Blendrahmen 4 sind teilweise von einem transparenten Abdeckband 5 abgedeckt, das an der einen Seite, mit der es auf der Leiterplatte 1 haftet, mit einer Beschichtung aus einer Klebstoffmasse versehen ist.

Das Abdeckband 5 weist auf der Beschichtung einen elektrischen Leiter 6 auf, der mit dem Abdeckband 5 eine Einheit bildet. Der Leiter 6 besteht aus einem Gemisch aus Lack und Metallpulver. Anstelle des Metallpulvers kann auch Graphit oder Ruß verwendet werden. Nach Aufbringen des Abdeckbandes 5 auf die Leiterplatte 1 und den Blendrahmen 4 sind durch den Leiter 6 die Leiterbahnen 2 der Leiterplatte 1 und somit die zu galvanisierenden Oberflächen untereinander und mit dem Blendrahmen 4 verbunden.

Die Erfindung beschränkt sich in ihrer Anwendung selbstverständlich nicht auf Leiterplatten, sondern kann auch zum teilweisen Abdecken anderer zu galvanisierender Gegenstände verwendet werden.

## Patentanspruch

Für galvanische Prozesse bestimmtes Abdeckband zum teilweisen Abdecken der Oberfläche zu galvanisierender Gegenstände, insbesondere Leiterplatten, bestehend aus einem folienartigen Träger aus Papier oder Kunststoff und einer auf einer Seite des Trägers aufgebrachten Beschichtung aus einer Klebstoffmasse, die entweder selbstklebend ist oder bei der die Verklebung erst durch Wärmeaktivierung erfolgt, wobei auf der Beschichtung des Abdeckbandes (5) mindestens ein mit dem Abdeckband (5) eine Einheit bildender elektrischer Leiter (6) angeordnet ist, der die zu galvanisierenden Oberflächen der Leiterplatte (1) untereinander und mit dem Blendrahmen (4) verbindet, dadurch gekennzeichnet, daß der elektrische Leiter (6) des Abdeckbandes (5) aus einem Gemisch aus Lack und Metallpulver oder aus einem Gemisch aus Lack und Graphit oder Ruß besteht.

## Claim

Masking strip intended for electroplating processes, for the partial masking of the surface of articles to be electroplated, especially circuit boards, consisting of a film-like carrier made of paper or plastic and a coating applied to one side of the carrier and composed of an adhesive material which is either pressure-sensitive or in which bonding takes place only as a result of thermal activation, there being arranged on the coating of the masking strip (5) at least one electrical conductor (6) which is in one piece with the masking strip (5) and which connects to one another and to the stop frame (4) the surfaces of the circuit board (1) which are to be electroplated, characterised in that the electrical conductor (6) of the masking strip (5) consists of a mixture of varnish and metal powder or of a mixture of varnish and graphite or carbon black.

**Revendication**

Bande de masquage pour des procédés galvaniques destinée au masquage partiel des surfaces d'objets à galvaniser, en particulier de plaquettes pour circuits imprimés, se composant d'un support sous la forme d'une feuille en papier ou en matière plastique et d'une pellicule d'un matériau adhésif appliquée sur une face du support, matériau qui peut être auto-adhésif ou dont l'action adhésive résulte d'une activation par chauffage, dans laquelle est disposé sur la pellicule de la bande de masquage (5) au moins un conducteur électrique (6) formant avec la bande de masquage (5) une structure unitaire et qui raccorde l'une à l'autre et avec le châssis (4) les surfaces à galvaniser de la plaquette (1), caractérisée en ce que le conducteur électrique (6) de la bande de masquage (5) se compose d'un mélange de laque et d'une poudre de métal ou d'un mélange de laque et de graphite ou de noir de carbone.

FIG. 1

FIG. 2